# EUROPÄISCHE PATENTSCHRIFT

(11) **EP 0 631 407 B1**
(45) Veröffentlichungstag und Bekanntmachung des Hinweises auf die Patenterteilung: **05.09.2001**
(21) Anmeldenummer: 94201594.2
(22) Anmeldetag: 03.06.1994
(51) Int. Cl.: H04L 7/00, H03L 7/06

(54) **Verfahren und Vorrichtung zum phasengenauen Umschalten gleichgearteter Impulszüge mit unterschiedlicher Phasenlage**
Method and device for phase-exact commutation of homogeneous pulses with different phase relation
Procédé et dispositif de commutation à phase exact d'impulsions homogènes avec relation des phases différentes

(30) Priorität: 07.06.1993 CH 169693
(43) Veröffentlichungstag der Anmeldung: 28.12.1994
(73) Patentinhaber: ALCATEL, 75008 Paris (FR)
(72) Erfinder: Gürtler, Michal Oktavian, CH-8136 Gattikon (CH); Beerenwinkel, Rolf, CH-8044 Zürich (CH)
(74) Vertreter: Schätzle, Albin, Dipl.-Phys.

(56) Entgegenhaltungen:
- US-A- 5 208 740

## Beschreibung

Die Erfindung liegt auf dem Gebiet der Verarbeitung getakteter digitaler Signale und betrifft ein Verfahren und eine Vorrichtung zum phasengenauen Umschalten gleichgearteter Impulszüge mit unterschiedlicher Phasenlage, insbesondere von redundanten Taktsignalen in synchronen Systemen.

In grösseren synchronen Systemen mit digitaler Signalverarbeitung muss die Vielzahl vorhandener Baugruppen mit einem Taktsignal versorgt werden, das von einer einzigen Quelle abgeleitet ist. Ein Beispiel für ein solches System ist ein Knoten in einem modernen Telekommunikationsnetz, das nach den CCITT-Standards der Synchronen Digitalen Hierachie (SDH) betrieben wird, ein sogenannter SDH-Cross-Connect. Da die lückenlose Taktversorgung für das Funktionieren des Systems vital ist, muss diese gewährleistet werden können, auch wenn am einen oder andern Ort im System eine Störung oder gar ein Ausfall auftritt. Es ist daher üblich, die Taktversorgung und andere wichtige Systemteile redundant auszuführen. Die doppelt oder gar mehrfach vorhandenen Signale werden im System auf unterschiedlichen Wegen verteilt. An mehreren Stellen bestehen Querverbindungen, über die im Fehlerfall sofort auf eines der zusätzlich vorhandenen Signale umgeschaltet werden kann.

Der unterschiedlichen Laufzeiten wegen weisen jedoch die an einer Baugruppe anstehenden, gleichgearteten Signale - in der Regel sind dies Rechtecksignale mit einer festen Grundfrequenz, also zweiwertige Impulszüge - zueinander unterschiedliche Phasenlagen auf. Ein simples Umschalten würde unweigerlich zu einem Phasensprung führen, was Falschzählungen, fehlerhafte Datenübernahmen und ähnliches zur Folge hätte. Abgesehen davon, ist ein direktes Umschalten zwischen Signalen bei Auftreten eines Fehlers ohne Verlust zumindest einzelner Impulse nicht möglich. Es ist daher üblich, bei der Weitergabe von Signalen bewusst Verzögerungen in Kauf zu nehmen. Auf einer einzelnen Baugruppe, auf der verschiedene Signale über verschiedene Wege eintreffen, wird für jeden zeitkritischen Impulszug mit einer Einrichtprozedur eine individuelle Verzögerung eingestellt, so dass günstige Verhältnisse für die Datenverarbeitung geschaffen werden (Setup- und Hold-Zeiten der Daten in Bezug auf den Takt). Eine Verzögerung ermöglicht überdies, festgestellte Fehler zu überbrücken.

Ein gängiges Mittel für die taktgenaue Weitergabe eines Impulszugs ist, das weitergegebene Signal in einem Phase Locked Loop (PLL) zu generieren, dessen Führungsgrösse das ausgewählte, weiterzugebende Signal ist. Der PLL wird durch vereinzelte, kurzdauernde Fehler zwar geringfügig beeinträchtigt, generiert jedoch ein lückenloses Signal. Wird am PLL von der einen Führungsgrösse auf eine gleichgeartete - frequenzgleiche - andere mit andererer Phasenlage umgeschaltet, so wird zwar der Phasensprung vermieden, aber es resultiert ein längerer Einschwingvorgang auf die neue Phasenlage. Mit dieser neuen Phasenlage sind jedoch die durch die Einrichtprozedur erzielten, günstigen Verhältnisse in der zeitlichen Abfolge der massgebenden Impulsflanken gestört und es könnten Fehler aufreten. Insbesondere bei Taktimpulszügen gilt es, derartige Phasenveränderungen beim Umschalten zu vermeiden.

Es besteht also die Aufgabe, für Baugruppen eine zuverlässige, störungsfreie Taktverteilung mit einem Takt zu gewährleisten, der aus gleichgearteten Taktimpulszügen hervorgeht, die mit Laufzeitunterschieden auf der Baugruppe ankommen können und von denen der eine oder andere ausfallen oder unterbrochen werden kann.

Die Aufgabe wird durch ein Verfahren gemäss den charakteristischen Merkmalen des Patentanspruchs 1 und eine Vorrichtung mit den charakteristischen Merkmalen des Patentanspruchs 6 gelöst. Die Lösung zeichnet sich durch eine Umschaltung im Innern des Phase Locked Loops aus, genauer der Steuerspannung des PLL, in Verbindung mit einer zwei- bzw. mehrfach vorhandenen Phasenverschiebungs-Abgleichschaltung, von denen jeweils eine den ersten Teil des PLL ausmacht. Die Phasenverschiebungs-Abgleichschaltung ist im wesentlichen der Phasendiskriminator des PLL, ergänzt um eine einstellbare Verzögerung und eine nachführbare Korrekturspannung. Ist die Schaltung in den PLL eingeschaltet, bleiben die Verzögerung und die Korrekturspannung auf dem zuletzt ermittelten Wert eingestellt. In den übrigen Schaltungen wird die Verzögerung so eingestellt, dass die Phasenlage gegenüber dem ausgegebenen Impulszug grob auf null abgeglichen ist und die Korrekturspannung wird laufend so nachgeführt, dass sie die am Phasendiskriminator ausgegebene Phasenfehlerspannung kompensiert. Die Umschaltung der Steuerspannung des PLL erfolgt dann praktisch spannungsfrei und im wesentlichen ohne Phasenänderung und ohne Phaseneinschwingvorgang des Ausgangsimpulszugs.

Das Verfahren ist vorteilhafterweise auch dann anwendbar, wenn, das Taktsignal Synchronisiermarken für die Rahmensynchronisation trägt, wie zum Beispiel in SDH-Systemen. In diesem Fall besteht nämlich das Problem, dass ohne besondere Massnahme jede derartige Marke dem PLL einen Stoss versetzt, wie beim Auftreten eines Fehlers. Weiter ist es für eine vollständige Synchronisation dann erheblich, in welcher Richtung eine Phasendifferenz ausgeglichen wird; ohne zusätzliche Information wird ein PLL eine Phasenverschiebung von zum Beispiel 1,7π wie eine solche von -0,3π, also um 0,3π ausgleichen, wodurch eine Verschiebung um eine ganze Periodendauer des Takts resultiert.

Die störungsfreie Taktverteilung der genannten Art wird auch für mit Synchronisierinformation modulierte Taktimpulszüge sichergestellt, indem dem von einem auf die Synchronisiermarken unempfindlichen PLL erzeugten Takt die Synchronisiermarken eingefügt werden, und zwar auf Grund des Ergebnisses einer vergleichenden Rahmenüberwachung in der Phasenverschiebungs-Abgleichschaltung. Damit ist eine Synchronisierung des ausgegebenen Impulszugs auf den entsprechend verzögerten ausgewählten Impulszug möglich.

Vorteilhafterweis kann das Verfahren auch angewendet werden, wenn alle gleichgearteten Taktimpulszüge ausfallen. Ein mitlaufender Zähler zählt die vom PLL generierten Taktimpulse in der Rahmeneinfügeschaltung. Im Normalbetrieb wird er von der Rahmenüberwachung in der Phasenverschiebungs-Abgleichschaltung gesetzt. Bei Fehlen aller gleichgearteten Impulszüge ist er freilaufend und selbstsetzend bei Erreichen eines vorgegebenen Zählerstands. Eine vom Zählerstand beeinflusste Logikschaltung fügt die Synchronisierinformation in den auszugebenden Impulszug ein.

Die Erfindung wird nachstehend anhand einer Anwendung, einer Taktverteilung innerhalb eines SDH-Schaltverteilers, worin eine zuverlässige Taktverteilung von besonderer Bedeutung ist, genauer erläutert. Dabei wird auf die folgenden Figuren Bezug genommen:
- Figur 1:: Funktionsblöcke eines Schaltverteilers
- Figur 2:: Taktversorgung im Schaltverteiler
- Figur 3:: Blockschaltbild der massgebenden Teile eines Taktverteilers
- Figur 4:: Phasenverschiebungs-Abgleichschaltung

In modernen Telekommunikationsnetzen, die nach den CCITT-Standards der Synchronen Digitalen Hierarchie (SDH) betrieben werden, sind die Schaltverteiler in den Uebertragungsknoten, die sogenannten Cross-Connect-Systeme, von entscheidender Bedeutung. Ihre Hauptaufgabe, die verkehrenden Digitalsignale verschiedener Bitraten softwaregesteuert durchzuschalten, müssen sie mit hoher Zuverlässigkeit erfüllen, auch beim Vorliegen besonderer Umstände, wie etwa der Vornahme von Aenderungen im Netz während des Betriebs oder dem Ausfall einzelner Funktionen. Um den hohen Anforderungen genügen zu können, sind die Schaltverteiler modular und weitgehend redundant aufgebaut. Redundante Baugruppen müssen jederzeit einsatzbereit sein. Dies bedingt Umschaltungen innert kürzester Zeit.

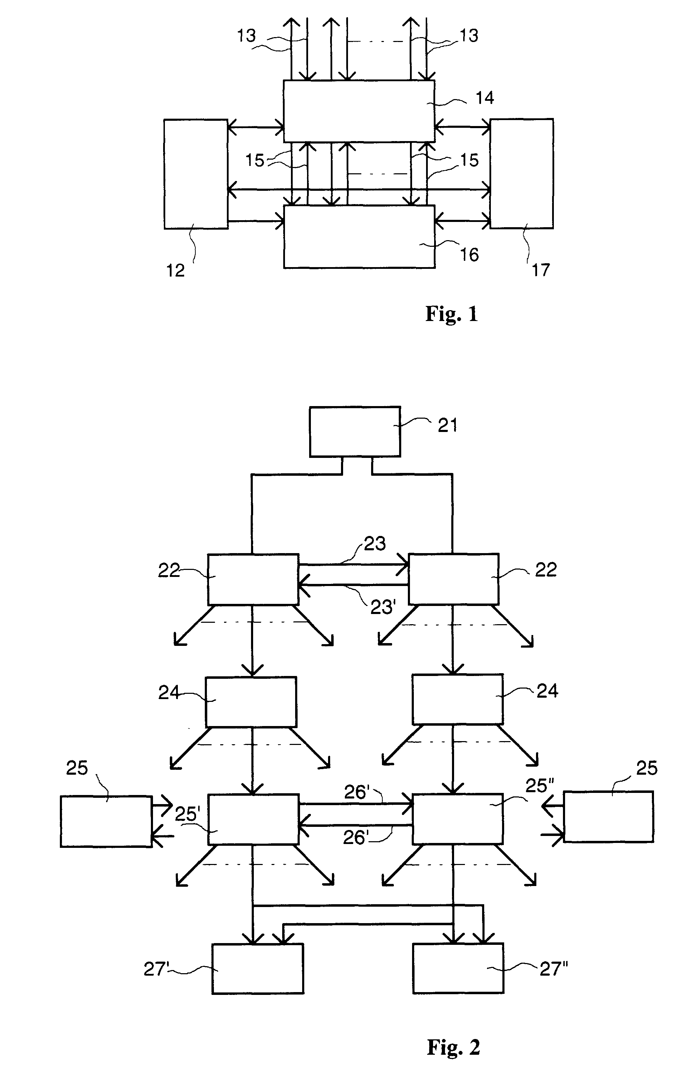

Gemäss Figur 1 besteht ein Schaltverteiler im wesentlichen aus einem mehrfachen Ein-/Ausgangsteil 14, einer Schaltmatrix 16, einer Steuerung 17 und einer Taktversorgung 12. Die elektrischen oder optischen Signale gelangen über die Anschlussleitungen 13 an einen mehrfachen Ein/Ausgangsteil 14, in dem die Eingangssignale elektrisch aufbereitet und ihrer Struktur gemäss teilweise zerlegt werden. Ueber eine entsprechende Anzahl von Datenleitungen 15 gelangen die Teile in die Schaltmatrix 16, wo sie den neuen Ausgängen zugeordnet werden, und von dort zurück an die entsprechenden Pforten des mehrfachen Ein-/Ausgangsteils 14. Dort werden die nun anstehenden Teile zu einem zu übertragenden Signal zusammengesetzt und für die Uebertragung über die Anschlussleitungen 13 umgesetzt. Das Ganze ist beeinflusst durch die Steuerung 17, die teils durch einen zentralen Rechner, teils durch lokale Prozessoren erfolgt. Von besonderer Bedeutung ist die Taktversorgung 12, die den synchronen Ablauf sicherstellt.

Die Figur 2 zeigt eine derartige Taktversorgung detaillierter - sie verdeutlicht auch das Prinzip der Modularität und Redundanz. Der Referenztakt mit einer genauen Frequenz um 2 MHz kann extern vorgegeben oder aus verarbeiteten Signale des Netzes abgeleitet sein; er wird von der Referenztaktaufbereitung 21 an zwei identische Systemtaktgeneratoren 22 geleitet, die daraus über einen Phase Locked Loop (PLL) je den Systemtakt von 155,5 MHz erzeugen und diesen an weitere Baugruppen der Taktversorgung verteilen. Die beiden Systemtaktgeneratoren sind gleichwertig. Ueber die Leitungen 23, 23' findet ständig ein Austausch der Takt- und Synchronisierinformation mit der Partnergrupppe statt. Im Fehlerfall oder beim Ausbau des einen der beiden Generatoren wird auf den Takt des andern umgeschaltet. Damit dies von den nachfolgenden Baugruppen unbemerkt geschehen kann, muss sichergestellt sein, dass die Phasenlage der beiden Impulszüge vor dem Umschalten bzw. dem Ausfall exakt übereinstimmt, was durch die weiter hinten beschriebene, erfindungsgemässe Vorrichtung des phasengenauen Umschalters erreicht wird. Ein Systemgenerator 22 bedient, allenfalls über Zwischenverteiler 24, die bei kleineren Systemen entfallen, eine Vielzahl von Taktverteilern 25. All diese Verteiler sind doppelt vorhanden und über die ganze Anlage verteilt angeordnet. Die Taktverteiler 25 sind ihrerseits paarweise über Leitungen 26, 26' miteinander verbunden, über die sie ihre Takte aufeinander abstimmen, so dass ein sprungfreies Umschalten auch an diesen Stellen jederzeit möglich ist. Ein Taktverteiler 25 bedient mehrere von der Taktversorgung abhängige Baugruppen 27. Ueblicherweise wird ein Taktverteiler 25' pro Baugruppenträger vorgesehen. Die in diesem Baugruppenträger vorhandenen Baugruppen 27' werden aber auch vom Partner-Taktverteiler 25" bedient und können gegebenenfalls an dessen Takt laufen. Umgekehrt bedient der Taktverteiler 25' auch die Baugruppen 27" des Partner-Taktverteilers 25". Derart sind sämtliche Einheiten über zwei eigenständige Wege mit Taktsignalen versorgt. Die Umschaltung erfolgt hier auf Befehl der Steuerung.

Schaltverteiler der beschriebenen Art weisen zum Beispiel 512 Anschlussleitungen für Signale mit 155 Mbit/s auf, was eine Einrichtung bedingt, deren Abmessungen in die Meter geht. Die Laufzeit der Impulse liegt in der Grössenordnung der Periodendauer von 6,4 ns des Systemtakts. Die Taktsignale erreichen daher die einzelnen Baugruppen mit nicht zu vernachlässigenden Laufzeitunterschieden. Die Daten wiederum laufen auf anderen Wegen durch die Baugruppen als die Taktsignale. An einer bestimmten Stelle im Schaltverteiler, an der Daten und Takt wieder zusammen wirken müssen, weisen deren massgebenden Impulsflanken gegenüber einem theoretisch exakten Taktzeitpunkt unterschiedliche Verzögerungen auf. Diese laufzeitbedingten Phasenunterschiede lassen sich im Groben durch Einfügen von Verzögerungsgliedern angleichen. Mit Hilfe einer variablen Verzögerungsleitung kann eine Baugruppe individuell abgeglichen werden.

Für die Umschaltung von einem Taktimpulszug auf einen redundanten andern von gleicher Frequenz spielt der Gesamtlaufzeitunterschied keine Rolle, solange der Impulszug gleichförmig ist. Massgebend ist jedoch die Phase zwischen den gleichgerichteten Flanken im Intervall (π,-π]. Zum einen sind im Cross-Connect-System nämlich auch modulierte Taktsignale vorgesehen. In jenen Impulszügen wird zum Zweck der Rahmensynchronisation alle 6 ms ein Impuls unterdrückt. Die Unterdrückung geschieht in Abhängigkeit des Zählerstandes einer Taktimpulszählung. Beim Umschalten vom einen, gleichförmigen Impulszug auf den redundanten darf diese Zählung nicht beeinträchtigt werden. Zum andern darf die Umschaltung nicht zu einem Phasensprung im Takt führen, der zur Folge hätte, dass eine zuvor gegenüber dem Takt vorlaufende Impulsflanke eines Datenstroms plötzlich nachlaufend würde oder umgekehrt; dies könnte das korrekte Funktionieren der Baugruppe verunmöglichen. Es besteht also die Notwendigkeit, die Taktsignale der zwei jeweils zusammenarbeitenden Taktverteiler 25 bzw. Systemtaktgeneratoren 22 an der vorgesehenen Umschaltstelle in ihren Phasenlagen einander anzupassen.

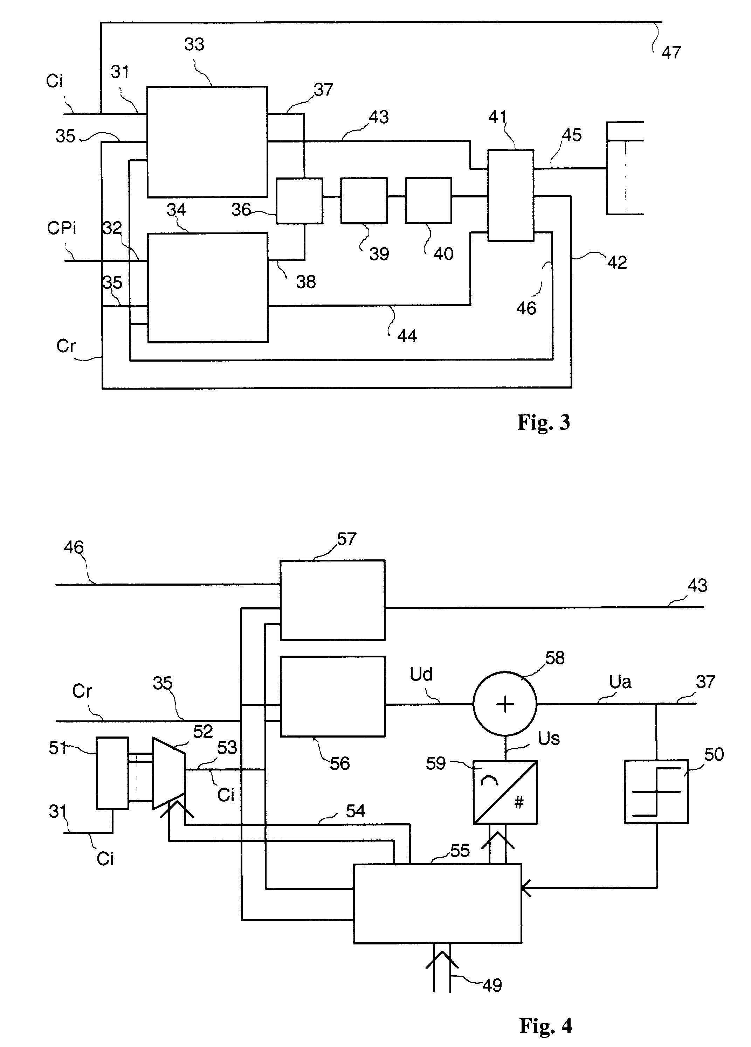

Die Figur 3 zeigt ein vereinfachtes Blockschaltbild der massgebenden Teile eines Taktverteilers 25', die eine sichere Weitergabe des Taktes ermöglichen, die da sind: zwei Phasenverschiebungs-Abgleichschaltungen 33, 34, ein elektronischer analoger Umschalter 36, ein integrierendes Filter 39, ein spannungsgesteuerter Oszillator 40 und eine Rahmeneinfügeschaltung 41. Ein erster Taktimpulszug, in der Folge mit Ci bezeichnet, stammt vom Systemtaktgenerator 22 bzw. einem Zwischenverteiler 24 und gelangt an den Eingang 31. Seine Leitung bildet am Eingang der Baugruppe eine Schlaufe und er wird über den Ausgang 47 an den Partner-Taktverteiler 25" geführt. Ein zweiter Taktimpulszug, in der Folge CPi genannt, stammt auf gleiche Weise vom Partner-Taktverteiler 25" und gelangt an den Eingang 32. Der Eingang 31 gehört zu einer ersten Phasenverschiebungs-Abgleichschaltung 33. Der Eingang 32 gehört zu einer identischen zweiten Phasenverschiebungs-Abgleichschaltung 34. An je einen weiteren Eingang 35 der zwei Schaltungen ist ein Referenztakt Cr, der in den anschliessenden massgebenden Teilen des Taktverteilers erzeugt wird, zurückgeführt. Am Ausgang 37 bzw. 38 liefern die Schaltungen je ein analoges Spannungssignal, das ein Mass für die Phasenverschiebung zwischen dem Referenztakt Cr und dem ersten Taktimpulszug Ci bzw. dem zweiten Taktimpulszug CPi ist. Der Ausgang 37 der ersten Phasenverschiebungs-Abgleichschaltung 33 und der Ausgang 38 der zweiten Phasenverschiebungs-Abgleichschaltung 34 sind je mit einem elektronischen analogen Umschalter 36 verbunden. Das jeweils durchgeschaltete Signal wird in einem integrierenden Filter 39 geglättet und trimmt einen spannungsgesteuerten Quartzoszillator 40. Dieser erzeugt eine ununterbrochene Impulsfolge von doppelter Frequenz des Systemtakts, in unserem Beispiel also von 311 MHz. Die nachfolgende Rahmeneinfügeschaltung 41 ist eine Zähl-, Logik- und Treiberschaltung. Sie erzeugt den Referenztakt Cr mit der halben Frequenz des Oszillators und einem exakten 1:1-Impulsbreitenverhältnis, der über die Rückführung 42 an die Eingänge 35 der beiden Phasenverschiebungs-Abgleichschaltungen 33, 34 gelangt.

Ueberlagert zu dieser Referenztakterzeugung durch einen Phase Locked Loop wird in der Phasenverschiebungs-Abgleichschaltung 33, 34 je der Synchronisationsimpuls für die Rahmen - im genannten Beispiel besteht die Modulation des Taktsignals in einer Impulsunterdrückung, die alle 6 ms stattfindet - extrahiert und über die Leitungen 43, 44 an die Rahmeneinfügeschaltung 41 weitergegeben. Diese erzeugt ihrerseits synchron zum extrahierten Signal den Synchronisationsimpuls. Das modulierte Taktsignal wird am Ausgang 45 über eine Treiberstufe an die Baugruppen 27 verteilt. Ueber die Steuerleitung 46 gelangt ein Fenstersignal zurück an die Phasenverschiebungs-Abgleichschaltungen 33, 34; es dient der Phaseneinstellung in der Phasenverschiebungs-Abgleichschaltung, deren Ausgang im Umschalter 36 nicht durchgeschaltet ist. Weitere Verbindungen zwischen den Phasenverschiebungs-Abgleichschaltungen 33, 34, der Rahmeneinfügeschaltung 41 und der Steuerung 17, die vor allem der Initialisierung und dem Austausch von Statusmeldungen dienen, sind nicht gezeichnet.

Die jeweilige Phasenverschiebungs-Abgleichschaltung 33, 34, von der das durch den elektronischen analogen Umschalter 36 durchgeschaltete Signal stammt, bildet zusammen mit dem Filter 39, dem spannungsgesteuerten Oszillator 40 und dem Frequenzteiler in der Rahmeneinfügeschaltung 41 über die Rückführung 42 einen Phase Locked Loop für den Referenztakt Cr im Vergleich mit dem jeweiligen Taktimpulszug Ci bzw. CPi. Die Modulationslücke im Taktimpulszug Ci bzw. CPi bedarf einer separaten Behandlung, welche durch die Rahmeneinfügeschaltung 41 und deren Verbindung mit der Phasenverschiebungs-Abgleichschaltung 33, 34 über die weiteren Leitungen 43, 44 erfolgt. Solange mindestens einer der beiden Taktimpulszüge Ci oder CPi vorhanden ist, gewährleistet der Regelkreis des Phase Locked Loop zusammen mit jenem der Synchronisierimpuls-Extraktion eine Taktversorgung, die genau synchron mit Ci bzw. CPi verläuft.

Wie bei Ausfall des einen Impulszugs ein phasengenaues Umschalten auf den andern erfolgt, wird gleich anschliessend beschrieben. Fällt nebst Ci noch CPi aus oder umgekehrt, wird statt einer Umschaltung der letzte Zustand gehalten, und die Taktversorgung ist zunächst nicht beeinträchtigt. Der Takt ist dann immer noch so genau, wie der Quartzoszillator frequenzstabil ist, und auch die Impulsunterdrückung für die Rahmensynchronisation erfolgt weiterhin durch die Rahmeneinfügeschaltung 41. Steht dann später Ci oder/und CPi an der Phasenverschiebungs-Abgleichschaltung 33, 34 wieder an, wird die Sychronisation mit dem Rahmentakt wieder hergestellt.

Die Phasenverschiebungs-Abgleichschaltung 33 erfüllt drei Aufgaben. Erstens vergleicht sie die Phasenverschiebung zwischen dem ersten Taktimpulszug Ci und dem Referenztakt Cr und liefert ein Steuersignal für den Oszillator 40. Zweitens speichert sie laufend den Korrekturwert, den es braucht, um das Steuersignal auf 0 abzugleichen. Drittens extrahiert sie die Modulationslücke in Ci. Dasselbe gilt natürlich für die Phasenverschiebungs-Abgleichschaltung 34 und den Taktimpulszug CPi. Im folgenden wird jeweils nur noch auf die eine, in Figur 4 beschriebene der beiden völlig gleichwertigen Phasenverschiebungs-Abgleichschaltungen Bezug genommen, auch wenn von der Funktion her die Partner-Schaltung gemeint ist. Die Figur 4 zeigt den prinzipiellen Aufbau, mit unter anderem einer Verzögerungsleitung 51, einem Multiplexer 52, einem Steuerzähler 55, einem Phasendetektor 56 und einer Rahmenüberwachung 57. Links sind die drei Eingänge der Phasenverschiebungs-Abgleichschaltung dargestellt, oben jener für das auf der Steuerleitung 46 zurückgeführte Fenstersignal, in der Mitte der Eingang 35 für den Referenztakt Cr und unten der Eingang 31 für den Taktimpulszug Ci. Letzterer ist auf eine temperaturkompensierte Verzögerungsleitung 51 mit beispielsweise 16 Abzweiganschlüssen geführt. Einer der Anschlüsse wird von einem Multiplexer 52 an dessen Ausgang 53 durchgeschaltet, von dem aus nun ein verzögerter Taktimpulszug Ci' an drei Funktionsblöcke verteilt wird, an die Rahmenüberwachung 57, den Phasendetektor 56 und den Steuerzähler 55. Der Referenztakt Cr vom Eingang 35 gelangt an dieselben Funktionsblöcke. Die Wahl des Anschlusses für die Durchschaltung im Multiplexer 52 geschieht durch die Adresse, die im Steuerzähler 55 festgelegt ist und über die Adressleitung 54 an den Multiplexer 52 weitergegeben wird. Diese Vorrichtung ermöglicht eine Phasenschiebung des Taktimpulszuges um etwa 1,3 Takteinheiten, womit ein Grobabgleich der Phase möglich ist.

Der Phasendetektor 56 ist in der für Phase Locked Loops bekannten Art ausgeführt. Er vermag eine Phasenverschiebung zwischen den beiden Eingangssignalen von vollen 360° zu verarbeiten. Die analoge, gefilterte Ausgangsspannung liefert das Steuersignal für den spannungsgesteuerten Quartzoszillator 40, sofern der Ausgang 37 über den Schalter 36 durchgeschaltet ist (vgl. Fig. 3). Für eine erste Taktangleichung in dieser ersten Betriebsart liefert der Digital/Analogwandler 59 keine Spannung an den Summator 58 und die Verzögerungsschaltung 51, 52 ist fest auf einen mittleren Wert eingestellt; der verzögerte Taktimpulszug Ci' am Ausgang 53 ist gegenüber dem Taktimpulszug Ci am Eingang 31 um einen festen Phasenbetrag verzögert. Es handelt sich also um einen üblichen Phase Locked Loop, der den Referenztakt Cr dem um einen festen Betrag verzögerten Taktimpulszug Ci' nachführt, wobei die Phase zwischen den beiden Impulszügen und damit auch die Ausgangsspannung im wesentlichen null ist.

Gleichzeitig arbeitet die zweite Phasenverschiebungs-Abgleichschaltung in der zweiten Betriebsart, bei welcher der Ausgang 37 nicht an den Oszillator 40 durchgeschaltet ist. Es erfolgt keine Nachsteuerung des Referenztakts Cr auf den verzögerten Taktimpulszug Ci'. Vielmehr wird bei dieser Betriebsart der Referenztakt Cr als massgebender Takt angesehen. Erfindungsgemäss ist die Schaltung intern nun so konditioniert, dass trotz einer voraussichtlich von null verschiedenen Phasenlage zwischen dem Referenztakt Cr und dem verzögerten Taktimpulszug Ci' am Ausgang 37 eine Ausgangsspannung Ua von null resultiert, was ermöglicht, jederzeit ohne Phasensprung im Phase Locked Loop von der einen Phasenverschiebungs-Abgleichschaltung auf die andere umzuschalten. Dies wird erreicht, indem in der nicht in den Phase Locked Loop eingeschalteten Phasenverschiebungs-Abgleichschaltung ein solcher simuliert wird. Eine Frequenzanpassung kann dabei natürlich nicht erfolgen, ist aber auch nicht nötig, da die Frequenz ja in allen Fällen dieselbe ist und bleibt.

Die Ausgangsspannung Ua am Ausgang 37 der Phasenverschiebungs-Abgleichschaltung wird auf einen Schwellwertdetektor 50 geführt, der aus der Polarität der Ausgangsspannung Ua ein logisches Signal ableitet. Dieses ist massgebend für die Zählrichtung im Steuerzähler 55. Das Zählresultat eines darin enthaltenen Zählers ergibt die Adresse für den Multiplexer 52, ist also massgebend für die Verzögerung des Taktimpulszugs Ci in den verzögerten Taktimpulszug Ci'. Dieser Zähler arbeitet unter der Kontrolle von externen Steuersignalen, die über die Steuerleitungen 49 den Steuerzähler 55 beeinflussen (setzen, zählen), und einer Vergleichsschaltung für die beiden Taktsignale, den Referenztakt Cr und den verzögerten Taktimpulszug Ci' (Zählfreigabe). Diese Massnahme bewirkt eine Phasenkorrektur im Groben, so dass die Phasenfehlerspannung Ud am Ausgang des Phasendetektors 56 um null herum zu liegen kommt. Der Feinabgleich erfolgt über eine Korrekturspannung Us, die vom Digital/Analogwandler 59 über den Summator 58 zur Ausgangsspannung Ua beiträgt. Der Wert der Korrekturspannung Us ist ebenfalls durch den Stand eines Zählers im Steuerzähler 55 gegeben, der in ähnlicher Weise wie oben beschrieben arbeitet. Die Korrekturspannung Us wird so lange nachgestellt, bis die Ausgangsspannung Ua null wird. Nötigenfalls muss der Multiplexer nochmals auf eine andere Verzögerung adressiert werden. Die inhärent vorhandene Phasenlage zwischen dem Referenztakt Cr und dem gerade nicht benützten Taktimpulszug Ci wird also einerseits durch die Einstellung der Verzögerung grob angeglichen, andererseits wird die der verbleibenden Verschiebung entsprechende Phasenfehlerspannung Ud durch eine Korrekturspannung Us ausgeglichen.

Erfolgt nun - aus welchen Gründen auch immer - durch den Umschalter 36 eine Umschaltung zwischen den Ausgängen 37 und 38, werden gleichzeitig die Zählerwerte in der Phasenverschiebungs-Abgleichschaltung, die neu in den PLL geschaltet ist, eingefroren. Die Umschaltung erfolgt im Idealfall spannungslos. Der PLL wird nicht gestört. Die Verzögerung und die Korrekturspannung Usbleiben stehen, werden aber nicht mehr weiter nachgestellt.

Vor einem erneuten Umschalten, zurück in die ursprüngliche Betriebsart, wird in der ersten Phasenverschiebungs-Abgleichschaltung ebenfalls die Verzögerung und die Korrekturspannung Us eingestellt. Natürlich ist zu erwarten, dass diese wiederum auf die mittlere Anzapfung bzw. null zu liegen kommen. Andere Werte infolge inzwischen veränderter Verhältnisse sind aber denkbar.

## Patentansprüche

1. Verfahren zum phasengenauen Umschalten gleichgearteter Impulszüge mit unterschiedlichen Phasenlagen, von denen der jeweils ausgewählte Impulszug über einen Phase Locked Loop den auszugebenden Impulszug bestimmt, **dadurch gekennzeichnet**, dass jeder Impulszug individuell verzögert und so die Phasenlage gegenüber dem auszugebenden Impulszug grob auf null abgeglichen wird, jeder nicht ausgewählte Impulszug mit dem auszugebenden Impulszug laufend verglichen und die der noch vorhandenen Phasendifferenz entsprechende Phasenfehlerspannung, wie sie im Phase Locked Loop als Steuerspannung wirksam würde, ermittelt, dieser eine entgegengesetzt gleiche Korrekturspannung hinzuaddiert und die Summe - die im wesentlichen null ist - als Ausgangsspannung zur Verfügung gehalten wird, und dass ein Umschalten auf einen andern Impulszug erfolgt, indem die betroffene Korrekturspannung auf dem momentanen Wert festgehalten und die zugehörige Ausgangsspannung an Stelle der vormals verwendeten Ausgangsspannung als Steuerspannung in den Phase Locked Loop geschaltet wird.

2. Verfahren nach Anspruch 1, wobei die in den gleichgearteten Impulszügen vorhandenen Synchronisiermarken dem auszugebenden Impulszug eingefügt sind.

3. Verfahren nach Anspruch 2, wobei der Vergleich der Impulszüge die vorhandenen Synchronisiermarken mit einschliesst, so dass auch Phasenverschiebungen um mehr als eine Impulsbreite festgestellt und korrekt abgeglichen werden können.

4. Verfahren nach Anspruch 1 oder 2, **dadurch gekennzeichnet**, dass bei Ausfall aller gleichgearteten Impulszüge die Steuerspannung an null geschaltet wird, so dass der auszugebende Impulszug mit einer von der zuletzt benutzten Frequenz unwesentlich abweichenden Frequenz weiter generiert wird.

5. Verfahren nach Anspruch 4, wobei ein mitlaufender Zähler die Synchronisiermarken generiert, die dem auszugebenden Impulszug eingefügt werden.

6. Vorrichtung zum phasengenauen Umschalten gleichgearteter Impulszüge mit unterschiedlicher Phasenlage, von denen der jeweils ausgewählte Impulszug über einen Phase Locked Loop den auszugebenden Impulszug bestimmt, **dadurch gekennzeichnet**, dass für jeden der gleichgearteten Impulszüge eine Phasenverschiebungs-Abgleichschaltung (33, 34) vorhanden ist, mit einem Eingang (31, 32) für den jeweiligen gleichgearteten Impulszug, einem weiteren Eingang (35) für den ausgegebenen Impulszug und einem Ausgang (37, 38) für die Ausgangsspannung (Ua), und dass ein elektronischer Umschalter (36) an den Ausgängen (37,38) der Phasenverschiebungs-Abgleichschaltungen (33, 34) Vorgesehen ist Zum wahlweisen Einschalten eines derselben in den Phase Locked Loop.

7. Vorrichtung nach Anspruch 6, **dadurch gekennzeichnet**, dass die Phasenverschiebungs-Abgleichschaltung (33, 34) im wesentlichen eine diskret einstellbare Verzögerungsleitung (51-52) für den gleichgearteten Impulszug, einen für Phase Locked Loops üblichen Phasendiskriminator (56), der eine von der Phase zwischen dem verzögerten Impulszug und dem ausgegebenen Impulszug abhängige Phasenfehlerspannung (Ud) liefert, und eine nachführbare Spannungsquelle (59-58-50-55) enthält, die am Ausgang (37) der Phasenfehlerspannung (Ud) eine Korrekturspannung (Us) überlagert, welche die Phasenfehlerspannung (Ud) kompensiert, solange die Phasenverschiebungs-Abgleichschaltung (33, 34) durch den elektronischen Umschalter (36) nicht in den Phase Locked Loop eingeschaltet ist, und welche mit dem Einschalten auf dem zuletzt eingestellten Wert festgehalten wird.

8. Vorrichtung nach Anspruch 7, **dadurch gekennzeichnet**, dass die diskret einstellbare Verzögerungsleitung (51-52) über eine Multiplexerschaltung (52) abgegriffen wird, deren Einstellung auf Grund des Phasenvergleichs automatisch so erfolgt, dass die kleinstmögliche Phasenverschiebung resultiert, und welche mit dem Einschalten der Phasenverschiebungs-Abgleichschaltung (33, 34) in den Phase Locked Loop auf dem zuletzt eingestellten Wert festgehalten wird.

9. Vorrichtung nach Anspruch 6, **dadurch gekennzeichnet**, dass im Phase Locked Loop eine Rahmeneinfügeschaltung (41) vorhanden ist, die im wesentlichen einen Zähler enthält, nach dessen Stand Synchronisiermarken in den auszugebenden Impulszug eingefügt werden, so dass auch bei Ausfall aller gleichgearteten Impulszüge ein vollständiger auszugebender Impulszug generiert wird.

10. Vorrichtung nach Anspruch 9, **dadurch gekennzeichnet**, dass die Rahmeneinfügeschaltung (41) mit jeder Phasenverschiebungs-Abgleichschaltung (33, 34) über eine Steuerleitung (46) verbunden ist, über die Synchronisiersignale ausgetauscht werden, und dass die Phasenverschiebungs-Abgleichschaltung (33, 34) eine Rahmenüberwachung (57) enthält, so dass die Rahmeneinfügeschaltung (41) auf den Rahmentakt synchronisiert wird.

## Claims

1. A method for the phase-accurate switching-over of similar pulse trains with different phase positions, of which the respective selected pulse train determines, via a phase locked loop, the pulse train which is to be output, **characterised in that** each pulse train is individually delayed and in this way the phase position relative to the pulse train which is to be output is roughly adjusted to zero, each non-selected pulse train is continuously compared with the pulse train to be output, and the phase error voltage corresponding to the phase difference still present, which would act as control voltage in the phase locked loop, is determined, an oppositely equal correcting voltage is added thereto, and the sum - which is substantially zero - is kept available as output voltage, and that a switch-over to another pulse train takes place in that the relevant correcting voltage is maintained at the instantaneous value and the associated output voltage is switched into the phase locked loop in place of the previously used output voltage by way of control voltage.

2. A method according to Claim 1, wherein the synchronising marks present in the similar pulse trains are inserted into the pulse train which is to be output.

3. A method according to Claim 2, wherein the comparison of the pulse trains includes the synchronising marks which are present, so that phase shifts of more than one pulse width can also be determined and correctly compensated.

4. A method according to Claim 1 or 2, **characterised in that** upon the failure of all the similar pulse trains, the control voltage is switched to zero, so that the pulse train to be output is further generated with a frequency differing unsubstantially from the last used frequency.

5. A method according to Claim 4, wherein an accompanying counter generates the synchronising marks which are inserted into the pulse train to be output.

6. A device for the phase-accurate switching-over of similar pulse trains with different phase positions, of which the respective selected pulse train determines, via a phase locked loop, the pulse train which is to be output, **characterised in that** for each of the similar pulse trains a phase shift adjustment circuit (33, 34) is provided, with an input (31, 32) for the respective similar pulse train, a further input (35) for the output pulse train, and an output (37, 38) for the output voltage (Ua), and that an electronic change-over switch (36) is provided at the outputs (37, 38) of the phase shift adjustment circuits (33, 34), for selectively switching one of these into the phase locked loop.

7. A device according to Claim 6, **characterised in that** the phase shift adjustment circuit (33, 34) substantially contains a discretely adjustable delay line (51-52) for the similar pulse train, a phase discriminator (56) commonly used for phase locked loops which supplies a phase error voltage (Ud) dependent upon the phase between the delayed pulse train and the output pulse train, and a trackable voltage source (59-58-50-55) which at the output (37) superimposes upon the phase error voltage (Ud) a correcting voltage (Us) which compensates the phase error voltage (Ud) for such time as the phase shift adjustment circuit (33, 34) is not switched into the phase locked loop by the electronic change-over switch (36) and which is maintained at the last set value when the phase shift adjustment circuit (33, 34) is switched into the phase locked loop.

8. A device according to Claim 7, **characterised in that** the discretely adjustable delay line (51-52) is tapped via a multiplexer circuit (52) which is set automatically on the basis of the phase comparison such that the smallest possible phase shift results, and which is maintained at the last set value when the phase shift adjustment circuit (33, 34) is switched into the phase locked loop.

9. A device according to Claim 6, **characterised in that** the phase locked loop comprises a frame insertion circuit (41) which substantially contains a counter, in accordance with the count of which synchronising marks are inserted into the pulse train to be output, so that even upon the failure of all the similar pulse trains a complete pulse train to be output is generated.

10. A device according to Claim 9, **characterised in that** the frame insertion circuit (41) is connected to each phase shift adjustment circuit (33, 34) via a control line (46) via which synchronising signals are exchanged, and that the phase shift adjustment circuit (33, 34) contains a frame monitor (57) so that the frame insertion circuit (41) is synchronised to the frame clock.

## Revendications

1. Procédé de commutation à phase exacte de trains d'impulsions homogènes avec des positions de phase différentes, dont le train d'impulsions respectivement sélectionné détermine le train d'impulsions à émettre par l'intermédiaire d'une boucle à verrouillage de phase (PLL), **caractérisé en ce que** chaque train d'impulsions est retardé individuellement et ainsi la position de phase est réglée approximativement sur 0 par rapport au train d'impulsions à émettre, chaque train d'impulsions non sélectionné est comparé en permanence avec le train d'impulsions à émettre et détermine la tension d'erreur de phase correspondant au déphasage encore présent, comme celle qui serait efficace dans la boucle à verrouillage de phase comme tension de commande, tension à laquelle est ajoutée une tension de correction identique dans le sens opposé et la somme, qui est sensiblement nulle, est mise à disposition comme tension de sortie, et en ce qu'une commutation s'effectue sur un autre train d'impulsions, du fait que la tension de correction concernée est maintenue sur la valeur momentanée et la tension de sortie correspondante est commutée comme tension de commande dans la boucle à verrouillage de phase à la place de la tension de sortie utilisée autrefois.

2. Procédé selon la revendication 1, les repères de synchronisation présents dans les trains d'impulsions multiples homogènes étant adaptés au train d'impulsions à émettre.

3. Procédé selon la revendication 2, la comparaison des trains d'impulsions incluant les présents repères de synchronisation, de sorte que même des déphasages de plus d'une largeur d'impulsion peuvent être constatés et compensés correctement.

4. Procédé selon la revendication 1 ou 2, **caractérisé en ce que**, en cas de défaillance de tous les trains d'impulsions homogènes, la tension de commande est commutée sur 0, de sorte que le train d'impulsions à émettre est généré à nouveau avec une fréquence peu différente de la dernière fréquence utilisée.

5. Procédé selon la revendication 4, un compteur rotatif générant les repères de synchronisation, qui sont ajoutés au train d'impulsions à émettre.

6. Dispositif de commutation à phase exacte de trains d'impulsions homogènes avec une position de phase différente, dont le train d'impulsions respectivement sélectionné détermine le train d'impulsions à émettre au moyen d'une boucle à verrouillage de phase, **caractérisé en ce qu**'un circuit de compensation de déphasage (33, 34) est présent pour chacun des trains d'impulsions homogènes, avec une entrée (31, 32) pour le train d'impulsions respectif homogène, une autre entrée (35) pour le train d'impulsions à émettre et une sortie (37, 38) pour la tension de sortie (Ua) et en ce qu'un inverseur (36) électronique est prévu sur les sorties (37, 38) des circuits de compensation de déphasage, pour l'enclenchement optionnel de l'un d'eux dans la boucle à verrouillage de phase.

7. Dispositif selon la revendication 6, **caractérisé en ce que** le circuit de compensation de déphasage (33, 34) contient essentiellement un circuit de retard (51 - 52) avec possibilité de réglage discret pour le train d'impulsions homogène, un discriminateur de phase (56) classique pour la boucle à verrouillage de phase, qui fournit une tension d'erreur de phase (Ud) dépendante de la phase entre le train d'impulsions ralenti et le train d'impulsions émis et une source de tension (59 - 58 - 50 - 55) pouvant être asservie, qui superpose à la sortie (37) de la tension d'erreur de phase (Ud) une tension de correction (Us), qui compense la tension d'erreur de phase (Ud), aussi longtemps que le circuit de compensation de déphasage (33, 34) n'est pas inséré par le commutateur (36) électronique dans la boucle à verrouillage de phase, et qui est maintenue avec l'insertion sur la dernière valeur réglée.

8. Dispositif selon la revendication 7, **caractérisé en ce que** le circuit de retard (51 - 52) avec possibilité de réglage discret est prélevé par un circuit multiplexeur (52), dont le réglage s'effectue automatiquement sur la base de la comparaison de phase de telle façon qu'il en résulte le déphasage minimum et qui est maintenu sur la dernière valeur réglée avec l'insertion du circuit de compensation de déphasage (33, 34) dans la boucle à verrouillage de phase.

9. Dispositif selon la revendication 6, **caractérisé en ce qu**'un circuit d'insertion de base (41) est présent dans la boucle de verrouillage de phase, qui contient pour l'essentiel un compteur, en fonction de la position duquel les repères de synchronisation sont insérés dans le train d'impulsions à émettre, de sorte qu'un train d'impulsions complet à émettre est généré même en cas de défaillance de tous les trains d'impulsions homogènes.

10. Dispositif selon la revendication 9, **caractérisé en ce que** le circuit d'insertion de base (41) est relié à chaque circuit de compensation de déphasage (33, 34) par une ligne de commande (46), par laquelle les signaux de synchronisation sont échangés, et en ce que le circuit de compensation de déphasage (33, 34) contient un dispositif de contrôle de base (57), de sorte que le circuit d'insertion de base (41) est synchronisé sur le rythme de base.
